# EUROPÄISCHE PATENTSCHRIFT

(11) **EP 0 297 308 B1**
(45) Veröffentlichungstag und Bekanntmachung des Hinweises auf die Patenterteilung: **08.09.1993**
(21) Anmeldenummer: 88108883.5
(22) Anmeldetag: 03.06.1988
(51) Int. Cl.: H02B 1/18

(54) **Schaltschrank**
Switchgear cubicle
Armoire de commutation

(30) Priorität: 02.07.1987 DE 3721901
(43) Veröffentlichungstag der Anmeldung: 04.01.1989
(73) Patentinhaber: Heidelberger Druckmaschinen Aktiengesellschaft, D-69019 Heidelberg (DE)
(72) Erfinder: Rodi, Anton, Dipl.-Ing. (FH), D-6906 Leimen 3 (DE); Blaser, Peter Theobald, Dipl.-Ing. (FH), D-6912 Dielheim (DE); Lehnert, Michael, Dipl.-Ing. (FH), D-6900 Heidelberg (DE)
(74) Vertreter: Stoltenberg, Heinz-Herbert Baldo

(56) Entgegenhaltungen:
- DE-A- 3 517 149
- US-A- 3 691 432
- US-A- 4 495 780

## Beschreibung

Die Erfindung betrifft einen Schaltschrank für elektrische (mit hoher Verlustleistung) und/oder elektronische (mit niedriger Verlustleistung) Komponenten mit einem ersten mit einem Lüfter und Lüftungsöffnungen versehenen Bereich und einem mittels einer Trennwand von dem ersten Bereich getrennten zweiten Bereich.

Es ist allgemein bekannt, zur Unterbringung elektrischer oder elektronischer Komponenten modular aufgebaute Schaltschränke zu verwenden. Diese besitzen üblicherweise ein 19-Zoll-Raster und können in Reihenbauweise aufgebaut werden. Der Grundaufbau der Schaltschränke besteht aus einer Rahmenkonstruktion mit Aussenwänden und Montagewänden, wobei zur Abführung der entstehenden Verlustwärme Wärmetauscher vorgesehen sind.

Nachteile dieser bekannten Schaltschränke sind der hohe mechanische Fertigungsaufwand und durch die doppelten Wände eine schlechte wärmeabstrahlung. Außerdem ist insbesondere bei einer großen abzuführenden Wärmemenge ein aufwendiges Wärmetauschersystem erforderlich, wie z B. in der US-A 4,495,780 beschrieben.

Die DE-A-35 17 149 beschreibt eine Kühlvorrichtung zum Abführen von Wärme aus einem mindestens ein wärmeerzeugendes, elektrisches oder elektronisches Bauteil enthaltenden Innenraum eines Gehäuses. Die Kühlvorrichtung weist einen metallischen Rippenkörper und einen, dem Einblasen von Kühlluft in die ihm offen zugewandten Luftkanäle des Kühlkörpers dienenden Ventilator auf. Die Längsrichtung der Luftkanäle des Rippenkörpers ist derart schräg zur durch den Rippenkörper noch unabgelenkten, auf ihn zuströmenden Kühlluftströmung geneigt, daß sich an den metallischen Kühlrippen kein Faserflug in die Wärmeableitung in störendem Ausmaß beeinträchtigendem Umfange absetzt.

Die Aufgabe der Erfindung liegt darin, einen aus zwei Bereichen bestehenden Schaltschrank zu schaffen, der eine möglichst wirkungsvolle Wärmeabfuhr für die in beiden Bereichen entstehende Wärme ermöglicht und der einen Bereich bei der Wärmeabfuhr mittels einer Luftströmung dabei möglichst staubfrei hält.

Diese Aufgabe wird erfindungsgemäß dadurch gelöst, daß
- der erste Bereich zur Aufnahme von Komponenten hoher Verlustwärme, vorzugsweise Trafos und Drosseln, vorgesehen ist,
- der zweite Bereich zur Aufnahme von Komponenten geringer Verlustwärme, vorzugsweise elektronische Schaltkreise, vorgesehen und spritzwasser- und staubdicht abgeschlossen ist,
- die Trennwand als Trägerwand solcher mit Kühlkörpern versehenen Komponenten des zweiten Bereiches vorgesehen ist, die einerseits spritzwasser- und staubgeschützt untergebracht sein und andererseits eine höhere Verlustleistung aufweisen, wobei die Kühlkörper sich durch in der Trennwand angeordnete Durchbrüche in den ersten Bereich erstrecken,
- im oberen und unteren Teil der Außenwand des ersten Bereichs Lüftungsöffnungen zur Förderung von Außenluft mittels des Lüfters angeordnet sind, wobei die Außenluft aus den oberen Lüftungsöffnungen in den Innenraum des Bereiches entlang der die Kühlkörper tragenden Trennwand und anschließend durch die unteren Lüftungsöffnungen nach außen geführt wird.

Ein wesentlicher Vorteil der Erfindung besteht darin, daß nunmehr die Komponenten je nach erforderlicher Schutzart und je nach Wärmeentwicklung in unterschiedlichen Bereichen des Schaltschranks angeordnet werden können. Dies bedeutet, daß hochempfindliche Bauelemente, wie elektronische Schaltkreise und ähnliches, in einem staub- und spritzwassergeschützten Bereich (Bereich 2) angeordnet werden, wobei deren Verlustwärme über die Schaltschrankwände, also ohne Verwendung von Wärmetauschern oder ähnlichem, an die Umgebung abgegeben wird.

In einem ersten Bereich des Schaltschranks sind Komponenten mit hoher Verlustwärme, beispielsweise Trafos, Droseln, Kühlkörper oder ähnliches, untergebracht, die gegen Umwelteinflüsse weniger empfindlich sind, so daß deren Kühlung durch die Außenluft erfolgen kann. Die Außenluft wird dabei von oben angesaugt. Dies hat den weiteren Vorteil, daß diese Luft weniger Schmutz bzw. Staubpartikel enthält.

In einer Ausgestaltung der Erfindung wird vorgeschlagen, die Zwischenwand zwischen den beiden Bereichen des Schaltschranks als Trägerwand solcher Komponenten zu benutzen, die einerseits staubgeschützt untergebracht sein sollen und andererseits eine höhere Verlustleistung aufweisen. Zur Aufnahme dieser Komponenten ist die Zwischenwand mit Durchbrüchen versehen, so daß die den Komponenten zugeordneten Wärmeabstrahlelemente, wie z.B. Kühlkörper, sich in den ersten Bereich erstrecken können und deren Kühlung durch die Außenluft erfolgt.

Um die zur Wärmeabstrahlung erforderlichen Innenwände des zweiten Bereichs möglichst optimal zu nutzen, ist in einer weiteren Ausgestaltung der Erfindung vorgesehen, an einer Innenwand zur Befestigung von Komponenten nicht eine doppelte Montagewand, sondern lediglich einen Montagerahmen anzuordnen, welcher auf Stegen diese Komponenten tragen kann. Dieser Montagerahmen ist beispielsweise über Stehbolzen mit der Wand verbunden und ermöglicht somit den ungehinderten Wärmeaustausch.

Gemäß einer weiteren Ausgestaltung befindet sich die gesamte Starkstromverdrahtung innerhalb des ersten Bereichs des Schaltschranks. Damit ist gesichert, daß beim Anschließen des Schaltschranks an die Versorgungsspannungen und Inbetriebnahme ein Öffnen des zweiten Bereichs des Schaltschranks nicht erforderlich ist und somit unnötige Umwelteinwirkungen in den zweiten Bereich verhindert werden.

Zur optimalen Raumausnutzung des Schaltschranks ist vorgesehen, innerhalb des zweiten Bereichs einen schwenkbaren Platinenträger anzuordnen, der nach dem Öffnen des Schaltschranks aus demselben herausgeschwenkt werden kann und somit von allen Seiten gut zugänglich ist. Damit wird insbesondere die Endmontage der Komponenten wesentlich erleichtert. Selbstverständlich ist es auch möglich, die Komponenten im ersten Bereich auf ein herausschwenkbares Element zu setzen.

Ein solcher Schaltschrank kann Anwendung finden an einer Druckmaschine, hierbei dient der Schaltschrank zur Unterbringung sämtlicher elektrischer bzw. elektronischer Komponenten und vereinigt die gesamte Steuerung der Druckmaschine, die somit zentral aufgebaut ist. Diese zentrale Anordnung der Komponenten ermöglicht eine besonders einfache Wartung und ein einfaches Installieren sowohl der Druckmaschine, die im wesentichen frei von elektronischen Schaltungen ist, als auch des Schaltschranks, der komplett herstellbar und zur Inbetriebnahme der Druckmaschine lediglich durch Kabelverbindungen an die Druckmaschine anschließbar ist.

Weitere Vorteile sind in der nachfolgenden Beschreibung enthalten.

Anhand eines Ausführungsbeispiels wird die Erfindung näher erläutert.

Es zeigt:
- Fig. 1: eine Perspektivdarstellung eines Schaltschranks,
- Fig. 2: eine Teilfrontansicht im Schnitt eines Schaltschrankbereichs.

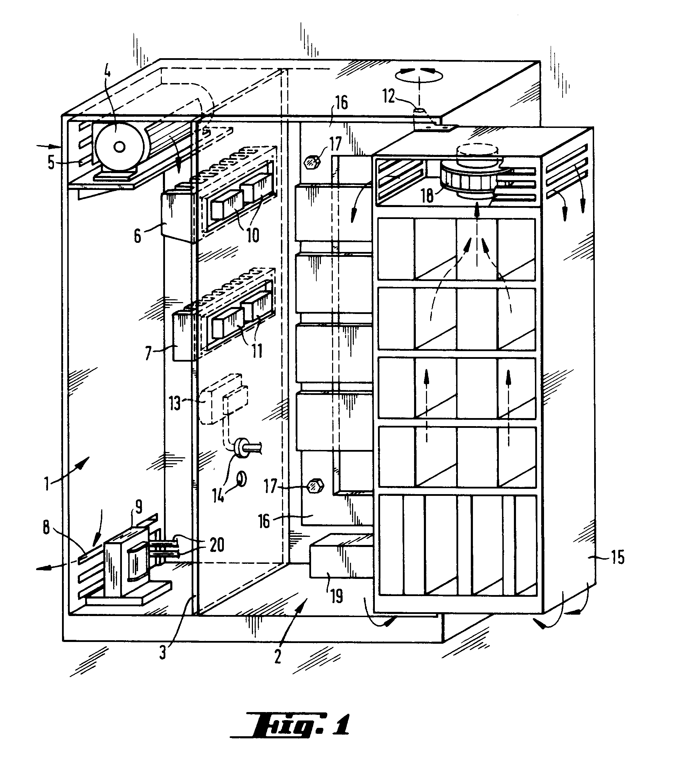

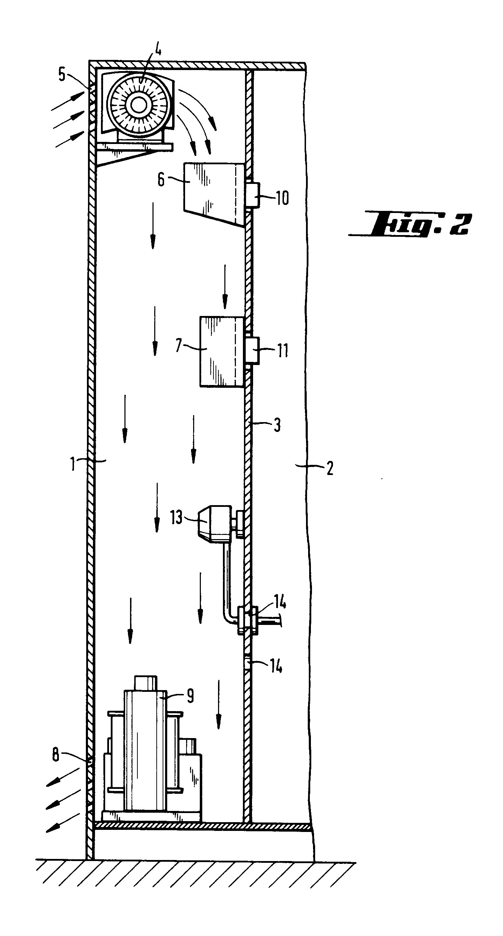

Der in Fig. 1 dargestellte Schaltschrank weist zwei Bereiche auf, einen ersten Bereich 1, der in Fig. 2 näher erläutert ist und einen zweiten Bereich 2. In Fig. 1 ist in dem Bereich 1 eine Kabeleinlaßöffnung mit Starkstromleitungen 20 gezeigt. Alle anderen darin befindlichen Teile sind im Zusammenhang mit Fig. 2 beschrieben.

Diese Bereiche sind durch eine Trennwand 3 staubdicht voneinander getrennt. Der Bereich 2 ist in Schutzart IP 54 aufgebaut, da hier empfindliche, elektronische Baugruppen untergebracht sind. Der Bereich 1 erfüllt mindestens Schutzart IP 20. Hier sind die Komponenten mit hoher Verlustleistung untergebracht, die außerdem geringere Anforderungen an die Schutzart stellen.

Wie der Fig. 2 zu entnehmen ist, befindet sich in dem Bereich 1 ein Querstromlüfter 4, welcher Außenluft ansaugt und von oben her dem Innern des Bereichs 1 zuführt. Die Luft wird über Luftschlitze 5 angesaugt und streicht laminar an Kühlkörpern 6,7, die eine hohe Verlustwärme abführen müssen, vorbei. An unteren Luftschlitzen 8 tritt diese durch einen Trafo 9 zusätzlich erwärmte Luft wieder aus dem Schaltschrank aus. Auf dieses Weise erzielt man in diesem Teil des Schrankes nahezu Umgebungstemperatur. Zusätzlich wird die von der Zwischenwand 3 übertragene Wärme aus dem Bereich 2 ebenfalls durch diese Luftzirkulation mit abgeführt. Durch einen hohen Luftaustausch und durch die Tatsache, daß im oberen Bereich des Schrankes die Luft angesaugt wird, bleibt der Verschmutzungsgrad sehr gering. Außerdem besteht die Möglichkeit an den Luftschlitzen 5 Staubfilter einzubauen. Die Kühlkörper 6,7 die innerhalb des Bereichs 1 angeordnet sind, können beispielsweise Leistungshalbleitern zugeordnet sein, welche sich im Bereich 2 befinden. Diese Leistungshalbleiter 10 befinden sich in diesem Fall auf der Trennwand 3 im Bereich 2. Zur Verbindung der Leistungshalbleiter 10,11, mit den Kühlkörpern 6,7 weist die Trennwand an diesen Stellen Durchbrüche auf, die durch die Kühlkörper verschlossen werden.

Weiterhin können sich auf der Trennwand 3 Bauelemente 13 befinden, die insgesamt in dem Bereich 1 angeordnet sind und lediglich deren Anschlüsse über staubdichte Kabeldurchführungen 14 in den Bereich 2 hineingeführt werden.

Ferner besteht die Möglichkeit, die Trennwand 3 zum Bereich 1 hin mit Kühlrippen zu versehen, so daß die im Bereich 2 entstehende Wärme besser über diese Trennwand abgeführt wird.

Im Bereich 2 des Schaltschranks befindet sich ein Schwenkrahmen 15, der die Elektronikkomponenten auf, beispielsweise steckbaren, Schaltplatinen beinhaltet. Dieser ist um den Drehpunkt 12 nach außen ca. 180 Grad schwenkbar, dadurch sind die Bauteile, bzw. Kabelanschlüsse auf dem Schwenkrahmen leicht zugänglich. Außerdem besteht durch das Herausschwenken die Möglichkeit, einen Montagerahmen 16, der an der Rückwand des Schaltschrankes, über Gewindebolzen 17 befestigt ist, zu bestücken oder zu verdrahten. Der Montagerahmen 16 besteht aus schmalen Stegen, so daß dieser nur einen geringen Teil der Rückwand des Schaltschranks verdeckt. Damit trägt die Rückwand erheblich zur Wärmeabstrahlung der im Innern des Bereichs 2 entstehenden Wärme bei.

Es besteht ferner die Möglichkeit, den Montagerahmen 16 zur Bestückung herauszunehmen, damit kann auf eine sonst übliche zweite Montagewand verzichtet werden.

Die Kühlung der gesamten Elektronik in diesem Bereich 2 erfolgt über Abstrahlung der Außenwände. Damit die durch die Elektronik erzeugte Wärme an die Außenwände geleitet wird, befindet sich auf dem Schwenkrahmen 15 ein Radiallüfter 18, welcher die Luft in vertikaler Richtung von unten nach oben durch die Elektronikeinschübe fluten läßt und im gesamten Bereich 2 des Schaltschrankes gleichmäßig verteilt. Dies führt somit zu einer hohen Ausnutzung der Schrankoberfläche zur Wärmeabstrahlung und reduziert außerdem örtliche Überwärmung. Dadurch läßt sich die überwiegende Verlustleistung der in diesem Schrank befindlichen Elektronik ohne Wärmetauscher an die Umgebung abführen. Im unteren Bereich des Schaltschrankes ist ein Kabeleinführungskasten 19 eingebaut.

Der Schrank besteht aus einer selbsttragenden Blechkonstruktion, so daß keine zusätzlichen Träger erforderlich sind. Durch den Schwenkrahmen 15 und den Montagerahmen 16 kann eine optimale Raumausnutzung, selbst bei hoher Verlustleistung der elektronischen Komponenten, erreicht werden.

Beide Bereiche werden durch, in den Figuren nicht dargestellte Türen,an der Frontseite abgeschlossen, wobei zumindest die Tür für den Bereich 2 luft- und staubdicht schließbar ist.

### BEZUGSZEICHENLISTE

- 1.: Bereich
- 2.: Bereich
- 3.: Trennwand
- 4.: Querstromlüfter
- 5.: Luftschlitze
- 6.: Kühlkörper
- 7.: Kühlkörper
- 8.: Luftschlitze
- 9.: Trafo
- 10.: Leistungshalbleiter
- 11.: Leistungshalbleiter
- 12.: Drehpunkt
- 13.: Bauelemente
- 14.: Kabeldurchführung
- 15.: Schwenkrahmen
- 16.: Montagerahmen
- 17.: Gewindebolzen
- 18.: Radiallüfter
- 19.: Kabeleinführungskasten
- 20: Starkstromleitungen

## Patentansprüche

1. Schaltschrank für elektrische (mit hoher Verlustleistung) und/oder elektronische (mit niedriger Verlustleistung) Komponenten mit einem ersten mit einem Lüfter (4) und Lüftungsöffnungen (5, 8) versehenen Bereich (1) und einem mittels einer Trennwand (3) von dem ersten Bereich getrennten zweiten Bereich (2),
**dadurch gekennzeichnet,**
daß:
- der erste Bereich (1) zur Aufnahme von Komponenten (9) hoher Verlustwärme, vorzugsweise Trafos (9) und Drosseln, vorgesehen ist,
- der zweite Bereich (2) zur Aufnahme von Komponenten geringer Verlustwärme, vorzugsweise elektronische Schaltkreise, vorgesehen und spritzwasser- und staubdicht abgeschlossen ist,
- die Trennwand (3) als Trägerwand solcher mit Kühlkörpern (6, 7) versehenen Komponenten (10, 11) des zweiten Bereiches (2) vorgesehen ist, die einerseits spritzwasser- und staubgeschützt untergebracht sein und andererseits eine höhere Verlustleistung aufweisen, wobei die Kühlkörper (6, 7) sich durch in der Trennwand (3) angeordnete Durchbrüche in den ersten Bereich (1) erstrecken,
- im oberen und unteren Teil der Außenwand des ersten Bereichs (1) Lüftungsöffnungen (5, 8) zur Förderung von Außenluft mittels des Lüfters (4) angeordnet sind, wobei die Außenluft aus den oberen Lüftungsöffnungen (5) in den Innenraum des Bereiches (1) entlang der die Kühlkörper (6, 7) tragenden Trennwand (3) und anschließend durch die unteren Lüftungsöffnungen (8) nach außen geführt wird.

2. Schaltschrank nach Anspruch 1, **gekennzeichnet durch** wenigstens einen in dem zweiten Bereich (2) angeordneten Umluftlüfter (18) zum Führen der von den Komponenten erzeugten Wärme an Innenseiten von mittelbaren oder unmittelbaren Außenwänden des Schaltschrankes.

3. Schaltschrank nach Anspruch 1,2 oder 3, **dadurch gekennzeichnet,** daß wenigstens eine Innenwand des zweiten Bereichs (2) einen Montagerahmen (16) aufweist, welcher derart gestaltet ist, daß die Wärme über diese Wand nach außen abgeführt werden kann.

4. Schaltschrank nach einem der vorherigen Ansprüche, **dadurch gekennzeichnet,** daß Starkstromleitungen (20) im ersten Bereich (1) anschließbar sind.

5. Schaltschrank nach einem der vorherigen Ansprüche, **dadurch gekennzeichnet,** daß der zweite Bereich (2) einen Schwenkrahmen (15) zur Aufnahme von Platinen aufweist, welcher herausschwenkbar im Schaltschrank angeordnet ist.

6. Schaltschrank nach einem der vorherigen Ansprüche, **dadurch gekennzeichnet,** daß die Komponenten zur Ansteuerung und elektrischen Versorgung einer Druckmaschine vorgesehen sind.

## Claims

1. Switch cabinet for electrical (with a high power loss) and/or electronic (with a low power loss) components having a first region (1), which is provided with a fan (4) and ventilation openings (5, 8), and a second region (2), which is separated from the first region by means of a separating wall (3), characterised in that:
- the first region (1) is provided for accommodating components (9) having high heat losses, preferably transformers (9) and inductors,
- the second region (2) is provided for accommodating components having low heat losses, preferably electronic circuits, and is closed such that it is shower-proof and dust-tight,
- the separating wall (3) is provided as a supporting wall for those components (10, 11) in the second region (2) which are provided with heat sinks (6, 7) which on the one hand are accommodated in a shower-proof and dust-protected manner and on the other hand have a relatively high power loss, the heat sinks (6, 7) extending into the first region (1) through perforations which are arranged in the separating wall (3),
- ventilation openings (5, 8) for conveying external air by means of the fan (4) are arranged in the upper part and lower part of the outer wall of the first region (1), the external air being passed from the upper ventilation openings (5) into the internal space of the region (1) along the separating wall (3) which supports the heat sinks (6, 7), and subsequently through the lower ventilation openings (8) to the exterior.

2. Switch cabinet according to Claim 1, characterised by at least one circulation fan (18), which is arranged in the second region (2), for passing the heat which is produced by the components to the inner sides of indirect or direct outer walls of the switch cabinet.

3. Switch cabinet according to Claim 1, 2 or 3, characterised in that at least one inner wall of the second region (2) has a mounting frame (16) which is designed in such a manner that the heat can be dissipated to the exterior via this wall.

4. Switch cabinet according to one of the preceding claims, characterised in that heavy-current lines (20) can be connected in the first region (1).

5. Switch cabinet according to one of the preceding claims, characterised in that the second region (2) has a pivoting frame (15) for accommodating boards, which pivoting frame (15) is arranged in the switch cabinet such that it can be pivoted out.

6. Switch cabinet according to one of the preceding claims, characterised in that the components are provided for driving and for the electrical supply of a printing press.

## Revendications

1. Coffret de commutation pour composants électriques (à forte dissipation de puissance) et/ou électroniques (à faible dissipation de puissance), comprenant une première zone (1) dans laquelle se trouvent un ventilateur (4) et des trous de ventilation (5, 8), ainsi qu'une seconde zone (2) séparée de la première par une cloison de séparation (3), caractérisé en ce que :
- la première zone (1) est prévue pour loger des composants (9) à forte dissipation de chaleur, de préférence des transformateurs (9) et des selfs,
- la seconde zone (2) est prévue pour loger des composants à faible dissipation de chaleur, de préférence des circuits électroniques et elle est fermée de manière étanche aux projections d'eau et à la poussière,
- la cloison de séparation (3) est prévue en cloison de support de composants (10, 11) de la seconde zone (2) qui sont équipés de dissipateurs de chaleur (6, 7) et qui d'une part doivent être logés en étant protégés contre les projections d'eau et la poussière et d'autre part sont affectés d'une forte dissipation de puissance, les dissipateurs de chaleur (6, 7) pénétrant dans la première zone (1) par des traversées de la cloison de séparation (3),
- des trous de ventilation (5, 8) sont disposés à la partie supérieure et à la partie inférieure de la cloison extérieure de la première zone (1) pour le transport d'air ambiant au moyen du ventilateur (4), l'air ambiant étant dirigé des trous supérieurs de ventilation (5) dans le volume interne de la zone (1) le long de la cloison de séparation (3) qui supporte les dissipateurs de chaleur (6, 7), puis vers l'extérieur par les trous inférieurs de ventilation (8).

2. Coffret de commutation selon la revendication 1, caractérisé par au moins un ventilateur (18) de circulation d'air disposé dans la seconde zone (2) et destiné à diriger la chaleur dégagée par les composants sur les côtés intérieurs de cloisons extérieures indirectes ou directes du coffret de commutation.

3. Coffret de commutation selon la revendication 1, 2 ou 3, caractérisé en ce qu'au moins une cloison intérieure de la seconde zone (2) comporte un cadre de montage (16) qui est conçu de manière que la chaleur puisse être évacuée vers l'extérieur par cette cloison.

4. Coffret de commutation selon l'une des revendications précédentes, caractérisé en ce que des conducteurs de courant fort (20) peuvent être raccordés dans la première zone (1).

5. Coffret de commutation selon l'une des revendications précédentes, caractérisé en ce que la seconde zone (2) comprend un châssis pivotant (15) de logement de platines, qui est monté dans le coffret de commutation de manière à pouvoir pivoter vers l'extérieur.

6. Coffret de commutation selon l'une des revendications précédentes, caractérisé en ce que les composants sont prévus pour la commande et l'alimentation électrique d'une machine à imprimer.
